# EUROPEAN PATENT APPLICATION

(11) **EP 3 062 115 A1**
(43) Date of publication of application: **31.08.2016**
(21) Application number: 16155779.8
(22) Date of filing: 15.02.2016
(51) Int. Cl.: G01R 1/04, G01R 31/28

(54) **INTERCHANGEABLE TEST PANELS FOR USE IN AUTOMATED TEST EQUIPMENT**

(30) Priority: 25.02.2015 US 201514630851
(71) Applicant: Honeywell International Inc., Morris Plains, NJ 07950 (US)
(72) Inventor: BOSQUES, Gerardo Javier Perez, Morris Plains, NJ 07950 (US)
(74) Representative: Houghton, Mark Phillip

(57) **Abstract**

A method and assembly for an interchangeable test panel (ITP) for use in an automated test environment is provided. The ITP (i) occupies less than an entire surface of the housing, (ii) contributes to the housing's structural integrity when mounted to the housing, (iii) co-locates the through-holes required by a test program, and (iv) is removable and interchangeable, providing multi-DUT support.

## Description

### TECHNICAL FIELD

The present invention generally relates to housings utilized in automated test equipment, and more particularly relates to using interchanging test panels (ITP) to enable reuse of said housings.

### BACKGROUND

Prior to being placed into their intended application, electronic devices are often tested by automated test equipment (ATE), with minimal human interaction. The ATE typically runs device-specific computer generated software tests. Hardware, in the form of electronic circuitry, is employed to interface the ATE with a specific electronic device.

A customized housing is generally required to enclose the electronic circuitry and support electronic components that are used to route a variety of signals and test points from the electronic circuitry to the electronic device under test (DUT). In many instances, through-holes in the housing receive and support the respective electronic components, resulting in a housing that is customized to the DUT.

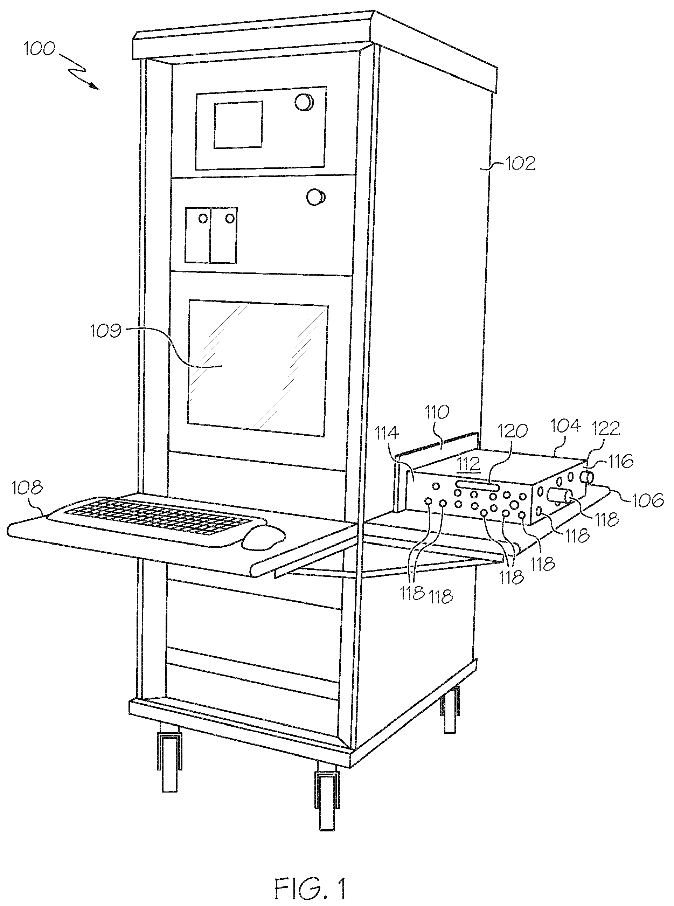

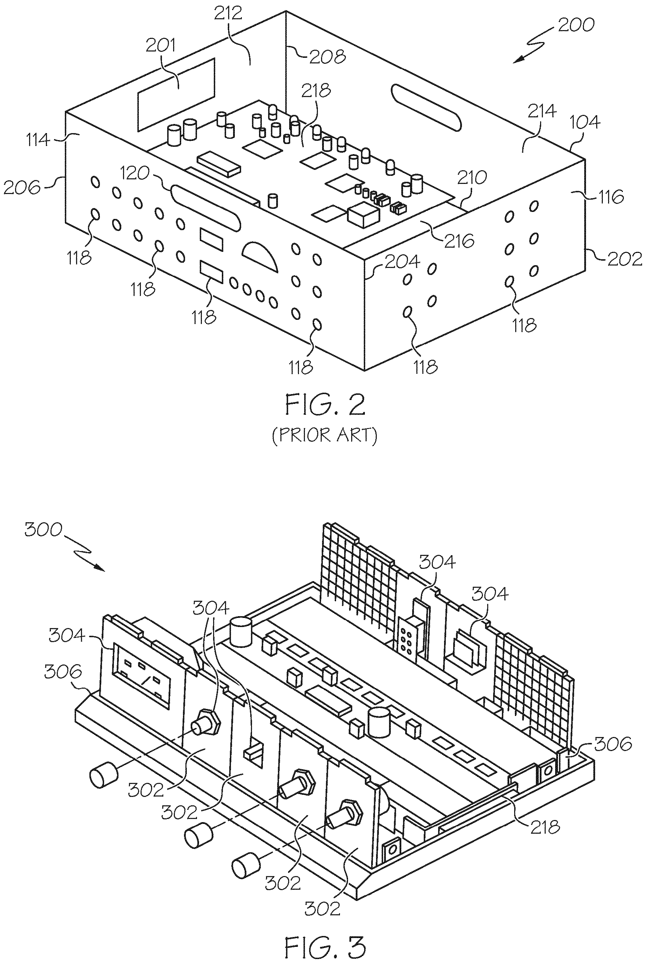

The housing must have the structural integrity to bear the weight of the electronic components, such as wires, switches, connectors, digital displays, power supplies, or the like, for the duration of time that testing entails. The need for structural integrity favors housings comprised of single-piece panels that are welded or otherwise fixedly mounted together, as is depicted in FIG. 1 and FIG. 2. However, fixedly mounting all surfaces of the housing is impractical because it can foreclose the ability to reuse the housing to test a different DUT, and thus prohibit access to the electronic circuitry inside.

On the other hand, housings that are created with multiple removable surfaces and/or through-holes distributed around multiple surfaces, as depicted in FIG. 3, may not be capable of bearing the significant weight of the aforementioned cables, connectors, switches, and the like. If the housing structure is not sufficiently robust it may deform or break in response to the added weight. Therefore, a method and assembly for configuring a housing to a DUT while minimizing the impact of the through-holes and electronic components are desired.

Accordingly, a test panel for use in an automated test environment that (i) occupies less than an entire surface of a housing, (ii) contributes to the housing's structural integrity when mounted to the housing, (iii) co-locates the through-holes required by a test program, and (iv) is removable and interchangeable, providing multi-DUT support, is desirable. The desired test panel maximizes reuse of housings from one DUT to another DUT, providing multi-DUT support, and reducing cost.

### BRIEF SUMMARY

This summary is provided to introduce a selection of concepts in a simplified form that are further described below in the Detailed Description section. This summary is not intended to identify key features or essential features of the claimed subject matter, nor is it intended to be used as an aid in determining the scope of the claimed subject matter.

In view of the foregoing, a method for providing multi-DUT support in automated testing is provided. The method comprises determining a first plurality of electrical components required to interface a first software test with a first device; specifying, at a processor, a first test panel, defined in part by an arrangement of through-holes, wherein each through-hole is associated with a respective electrical component of the first plurality electrical components; and machining the first test panel from a single, continuous, planar material.

An assembly for use in an automated test environment is provided. The assembly comprises a housing configured to enclose a first instance of electronic circuitry associated with a first software test. The housing comprises a surface having a first opening adapted to removably and interchangeably receive a test panel. The assembly also includes a first test panel configured to be mounted to the opening and to interface the first instance of electronic circuitry with a first electronic device.

Another method, executable by a processor, for customizing a housing used in an automated test environment, is provided. A first software test associated with a first electronic device is generated and a first plurality of electrical components required by the first software test is determined. A first arrangement of through-holes, defining a first test panel, is specified, wherein each through-hole is associated with a respective electrical component of the first plurality electrical components. The first test panel is machined from a single, continuous, planar metallic material, and removably mounted to an opening in the housing that is configured to receive a test panel.

Other desirable features and advantages will become apparent from the following detailed description and the appended claims, taken in conjunction with the accompanying drawings and this background.

### BRIEF DESCRIPTION OF THE DRAWINGS

A more complete understanding of the subject matter may be derived by referring to the following Detailed Description and Claims when considered in conjunction with the following figures, wherein like reference numerals refer to similar elements throughout the figures, and wherein:
FIG. 1 is a diagram of a traditional automated test environment configured for testing a first DUT (not shown);
FIG. 2 is a simplified three dimensional view of a prior art embodiment of the traditional housing of FIG. 1;
FIG. 3 is a view of a portion of another prior art housing;
FIG. 4 is a side view of a housing, showing an opening for receiving an interchangeable test panel, in accordance with the exemplary embodiment;
FIG. 5 is an example of an interchangeable test panel, in accordance with the exemplary embodiment; and
FIG. 6 is a flow chart of a process for generating an interchangeable test panel, in accordance with the exemplary embodiment.

### DETAILED DESCRIPTION

The following Detailed Description is merely exemplary in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over any other implementations. Furthermore, there is no intention to be bound by any expressed or implied theory presented in the preceding Technical Field, Background, Brief Summary or the following Detailed Description.

For the sake of brevity, functional aspects of various automated test equipment systems and subsystems (and the individual operating components thereof) may not be described in detail herein.

The following descriptions may refer to elements or features being "coupled" together. As used herein, unless expressly stated otherwise, "coupled" means that one element/node/feature is directly or indirectly joined to, mated with, or directly or indirectly communicates with, another element/node/feature; coupling is not necessarily mechanical. Thus, although the drawings may depict one exemplary arrangement of elements, additional intervening elements, devices, features, or components may be present in an embodiment of the depicted subject matter. In addition, certain terminology may also be used in the following description for the purpose of reference only, and thus are not intended to be limiting.

In this document, relational terms, such as first and second, may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

FIGs 1-3 are illustrations of prior art. FIG. 1 is a prior art diagram of an automated test environment **100** configured for testing a first DUT (not shown). FIG. 2 is a view **200** of a prior art embodiment of the traditional housing **104** from FIG. 1 that relies on fixedly mounted panels and through-holes in multiple locations. FIG. 3 is a portion of a prior art housing **300** comprising a plurality of pre-fabricated tiles, each with a single precut through-hole, and each tile being mounted to the housing via a tongue and groove. As will be described in connection with FIGs 2-3, when assembled, housing **104** typically has a cuboid shape. It should be noted that, although it is common to refer to the housing **104** as a "box," or an "interface test adapter (ITA) box," and the housing is typically cuboid, the housing **104** may take on any shape or form that enables interfacing with the ATE **102** and running software tests on the DUT. FIGs 1-3 are discussed in more detail below.

FIG. 1 is a diagram of a traditional automated test environment **100** configured for testing a first DUT (not shown). A typical instance of automated test equipment (ATE) **102** includes a processor, memory, user interface **108** and a display **109**. A user may generate DUT-specific computer generated software tests on an instance of an ATE **102,** or may upload them from an external memory.

The traditional housing **104** is a prior art design, shown supported on an optional shelf **106,** and interfaced to automated test equipment (ATE) **102** via mass interconnect interface **110**. Mass interconnect interface **110** has an industry standard footprint, to which an interconnector module (not shown) mounted to housing **104** couples. The mass interconnect interface **110**/interconnector module combination serves to channel and direct signals, in accordance with a computer generated software test, between the ATE **102** and electronic circuitry enclosed within the housing **104**.

The traditional housing **104,** depicted in automated test environment **100,** is defined by six sides, five of which are fixedly mounted along edges. The top panel is typically mounted to the housing **104** via a hinge **122.** FIG. 1 depicts a view of top plate **112,** side panel **114** and front panel **116** of housing **104.** The side panel **114** is shown having a handle **120** and a plurality of through-holes **118**. Through-holes **118** are also distributed in front panel **116.** Each through-hole is configured to receive respective electrical components that are required to interface the DUT with DUT-specific electronic circuitry (FIG. 2, electronic circuitry **218**). Although many of the through-holes shown in FIG.1 appear to be of uniform dimension, through-holes may have a variety of shapes and sizes.

In operation, an instance of electronic circuitry (FIG. 2, electronic circuitry **218**) is generally used to route, condition, drive and monitor signals between the ATE **102** and a respective DUT. Once operational, the automated test environment **100** may be used to test other DUTs of the same type; automated test environment **100** may be relied upon to test a specific type of DUT for the months or years that the first (type of) DUT is relevant.

When it is time to switch from testing a first (type of) DUT to testing a second (type of) DUT, a computer generated software test that is associated with the second DUT is generated or uploaded into the ATE **102**. The second computer generated software test typically requires a second instance of electronic circuitry (FIG. 2, electronic circuitry **218**), which typically requires a second arrangement of electrical components for interfacing to the second DUT, which, in turn, generally requires a new arrangement of through-holes, arranged and configured in accordance with the second instance of electronic circuitry. As is readily understood, because of the fixedly attached panels, accommodating the second instance of electronic circuitry generally requires destruction of a traditional housing **104**. This incurs a tremendous amount of disassembly and assembly time, in addition to adversely affecting quality assurance cycle times.

FIG. 2 is a simplified three dimensional view **200** of a prior art embodiment of the traditional housing **104** from FIG. 1. Traditional housing **104** is cuboid, enclosed on all sides when the top panel is attached, comprising front panel **116,** left side panel **114**, right side panel **214,** and a bottom plate **216**. Edges **202, 204, 206, 208,** and **210** are fixedly mounted, generally via welding and/or threaded fasteners. Electronic circuitry **218** is typically secured on the bottom plate **216.** A rear panel **212** is shown with an opening **201** for receiving and supporting an interconnector module. Handles, such as handle **120,** may take on various forms and locations on the housing **104,** as required by the weight of the assembled housing **104**.

Left side panel **114** and front panel **116** are shown with a plurality of through-holes **118**. As described in connection with FIG. 1, the configuration, placement, shape, and size of through-holes **118** is in accordance with requirements of the electronic circuitry **218** and the DUT.

FIG. 3 is a view of a portion of another prior art housing **300**. A plurality of individual plates **302** are shown tiled together and fitted into a tongue and groove opening **306**. Each plate of the plurality of individual plates **302** has a through-hole that supports a single electrical component **304**. The individual plates **302** have fixed dimensions; this limits the options that may be supported in the generation of a housing **104** for use in an automated test environment **100**. In addition, a housing **104** designed using this methodology is replete with seams, gaps, steps and tongue and groove attachments that weaken structural integrity.

The figures that follow depict the proposed novel single-piece interchangeable test panel (ITP). Various embodiments are directed to a single-piece interchangeable test panel (ITP) for removably mounting to a housing used in automated test environments. The ITP is designed such that, when it is interchangeably and replaceably mounted to the housing, the housing meets the structural integrity requirements of the automated testing environment. Advantageously, the layout of the proposed ITP (i.e., the arrangement of through-holes according to a specific DUT) may be specified using currently available computer aided design (CAD) tools, and the ITP layout may be machined, using traditional machining equipment, into a continuous piece of material. The embodiments described herein are merely an example and serve as a guide for implementing the novel systems and method herein on any aviation, defense, industrial, commercial, or consumer automated testing application. As such, the examples presented herein are intended as non-limiting.

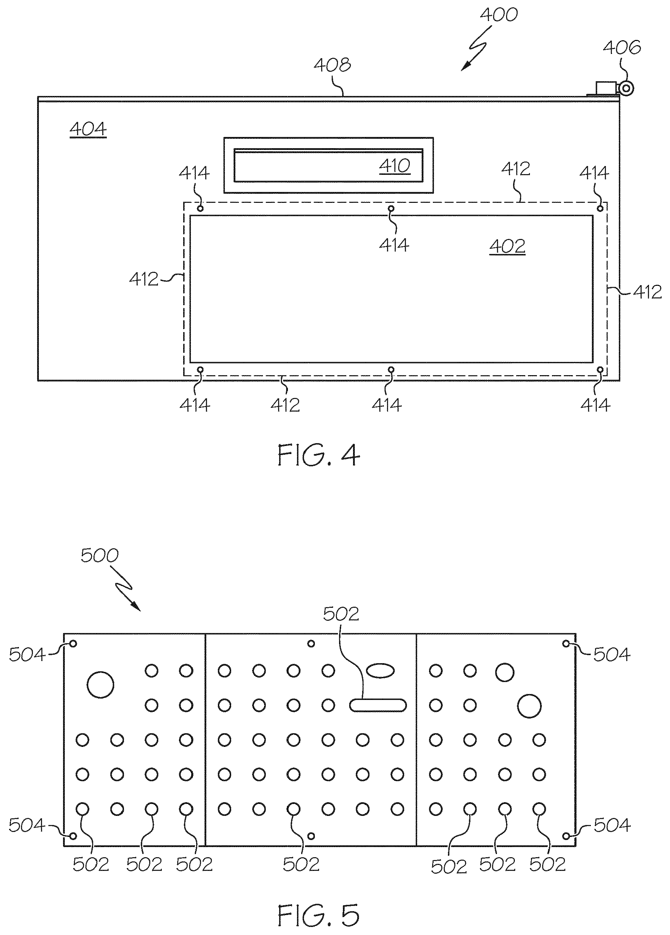

FIG. 4 is a side view of a housing **400,** showing an opening 402 for receiving an interchangeable test panel (ITP), in accordance with the exemplary embodiment. Top plate **408** is shown mounted to housing **400** via hinge **406**. Handle **410** is also shown.

Opening **402** is shown, created in surface **404** of housing **400.** Dotted lines **412** encircle opening **402** to indicate an area of overlap created when a respective ITP is removably and interchangeably mounted to the opening **402** in the surface **404. The** aforementioned area of overlap may accommodate additional openings **414** for placement of removable fastening devices, such as, but not limited to, threaded fasteners like screws and bolts. It is readily observable that opening **402** takes up less area than the area of the surface **404**. The dimensions of opening **402,** as well as the location of opening **402**, may be application specific.

FIG. 5 is an example of an ITP **500**, in accordance with the exemplary embodiment. As described, each instance of an ITP **500** is DUT specific and comprises a plurality of through-holes **502** arranged in accordance with DUT-specific electronic circuitry **218**. When assembled, the through-holes **502** are populated with the respective electrical components, such as cables, connectors, switches, and the like, which interface the DUT-specific electronic circuitry **218** with a DUT. As mentioned above, openings **504** may be placed around the perimeter of the ITP to accommodate removable fastening devices used to removably mount an ITP **500** to the opening **402**.

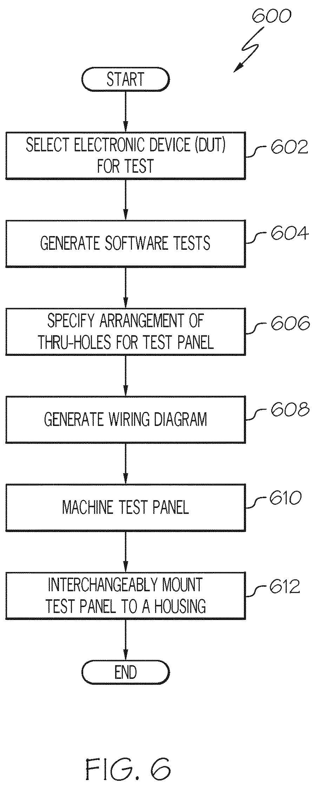

As will be described in more detail in connection with FIG. 6, the ITP described herein may realized using any mechanical computer automation design (CAD) software tool. A source file may be generated by the CAD tool, wherein the source file represents the specified arrangement of through-holes, including cutout definitions, sizes, and locations. The source file may also include or generate visual markings for the ITP that provide information about the electronic components or signals associated with each through-hole. The source file may additionally include or generate interconnection diagrams (wiring diagrams) for use in coupling an instance of electronic circuitry **218** to the ATE **102,** and to electrical components arranged on the ITP **500**.

FIG. 6 is a flow chart of a process **600** for generating an ITP **500**, in accordance with the exemplary embodiment. Process **600** and the CAD tools and machining tools described herein may be implemented or realized with one or more general purpose processors, content addressable memory devices, digital signal processors, application specific integrated circuits, field programmable gate array devices, any suitable programmable logic devices, discrete gate or transistor logic devices, discrete hardware components, or any combination designed to perform the functions described herein. A processor device may be realized as a microprocessor, a controller, a microcontroller, or a state machine. Moreover, a processor device may be implemented as a combination of computing devices, e.g., a combination of a digital signal processor and a microprocessor, a plurality of microprocessors, one or more microprocessors in conjunction with a digital signal processor core, or any other such configuration.

At STEP **602**, the electronic device to be tested (DUT) is selected. At STEP **604** DUT-specific computer generated software tests (hereinafter, "software tests"), designed to run on automated test equipment (ATE), are generated. In an automated test environment, the software tests are used to communicate, quickly perform measurements, and evaluate test results on one or more DUTs. The software tests may serve any function, but are generally designed to exhaustively and sequentially step a DUT through every combination of input controls and output signals to assure that the DUT properly performs the functions that it was designed to perform.

In order to run the software tests on the DUT, a DUT-specific instance of electronic circuitry **218**, configured to interface the respective DUT (via various electronic components) with the ATE **102** is generally required. The hardware is typically located external to the ATE **102** and external to the DUT. For the test program to run properly, the instance of electronic circuitry **218** must be coupled to the ATE **102**, and various signals and test points on the instance of electronic circuitry **218** must be coupled to the DUT; the required signals and test points are routed out through the housing and made accessible on an external surface of the housing, via various electronic components.

In the course of preparing to test a DUT, a housing is selected. The housing must have a surface with sufficient area to create an opening **402** capable of accommodating an ITP **500,** while meeting the structural stability requirements of an automated test environment. The housing may be"off the shelf" housing, such as an ITA, or a customized housing.

At STEP **606** an arrangement of through-holes is specified for an interchangeable test panel (ITP **500**). A computer automated design (CAD) tool may be utilized for this step. Specifying the arrangement of through-holes typically involves: identifying and quantifying the required inputs and outputs, and their corresponding required electrical components; and, planning for the dimensions and spatial arrangement of said electrical components. The dimensions and spatial arrangements may be based, in part, on the configuration of the instance of electronic circuitry **218**, the specific DUT, and any other application-specific issues.

At STEP **608** a wiring diagram may be generated. The wiring diagram provides instructions for interconnecting the components that will populate the arrangement of through-holes, the instance of electronic circuitry **218**, and the interconnector module **108**.

STEP **610** a single, continuous piece of material is machined with the arrangement of through-holes specified at STEP **606**, thereby becoming the ITP **500**. A source file from a CAD tool may be utilized to provide instructions for the machining tool. The ITP **500** may also be marked in the machining process, to assist in assembly. Typically, the material is metallic. Further assembly steps include populating the through-holes with the respective electronic components. At STEP **612**, the ITP **500** is replaceably and interchangeably mounted to the housing.

In some applications, a user may determine that a second ITP is desired for use, concurrent with a first ITP, during implementation of the first software test. Any additional ITPs may be machined on a single-piece of material using the process described above. ITPs may generally be placed on any surface of the housing, for example, corresponding to the left side panel **114**, right side panel **214**, front panel **116**, or on a top plate **112** of housing **104**. In other applications, the first ITP is sufficient, and a second ITP is only generated to support testing a second DUT.

Advantageously, the ITP **500** may be generated in a size and shape that conveniently couples to/assembles with an industry standard ITA box, or any customized housing that meets the requirements of the application. The interchangeable nature of the ITP **500** maximizes reuse of materials and minimizes the cycle time to change a test program setup from one type of DUT to another.

The test-program-specific ITPs introduced herein provide multi-DUT support with several advantages. First, as a single, continuous planar material (i.e., a single-piece test panel), the ITP averts the seams, gaps and steps that result from approaches to housing designs that piece together multiple individual plates, as shown in FIG. 3. In addition, by co-locating the through-holes required by each program into a single-piece test panel, any deleterious impact on the structural integrity of the combined ITA box and ITP may be controlled and minimized, resulting in increased durability and increased longevity for the housing. In summary, the test-program-specific ITPs, as provided by the exemplary embodiment, simplifies the build of a housing, reduces assembly time, reduces corresponding disassembly time, and promotes reuse of materials.

Thus, a test panel for use in an automated test environment that (i) occupies less than an entire surface of the housing, (ii) contributes to the housing's structural integrity when mounted to the housing, (iii) co-locates the through-holes required by a test program, and (iv) is removable and interchangeable, providing multi-DUT support, is provided. The interchangeable test panel maximizes reuse of housings from one test program to another, provides multi-program support, and reduces cost.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A method for providing multi-DUT support in automated testing, the method comprising:
determining a first plurality of electrical components required to interface a first software test with a first device;
specifying, at a processor, a first test panel, defined in part by an arrangement of through-holes, wherein each through-hole is associated with a respective electrical component of the first plurality electrical components; and
machining the first test panel from a single, continuous, planar material.

2. The method of Claim 1, further comprising replaceably and interchangeably mounting the first test panel to an opening (i) configured to receive a test panel and (ii) located on a surface of a housing.

3. The method of Claim 1, further comprising generating, in accordance with the first software test, a first wiring diagram for coupling a first instance of electronic circuitry to the first plurality of electrical components.

4. The method of Claim 3, further comprising enclosing within the housing the first instance of electronic circuitry.

5. The method of Claim 1, further comprising marking the first test panel with visual indicators in accordance with the first test program.

6. The method of Claim 2, further comprising:
determining a second plurality of electrical components required to interface a second software test with a second device;
specifying, at a processor, a second test panel defined in part by an arrangement of through-holes, wherein each through-hole is associated with a respective electrical component of the second plurality electrical components;
machining the second test panel from a single, continuous, planar material; and
replacing the first test panel with the second test panel.

7. An assembly for use in an automated test environment, the assembly comprising:
a housing (i) configured to enclose a first instance of electronic circuitry that is associated with a first software test, and (ii) comprising a surface having a first opening adapted to removably and interchangeably receive a test panel; and
a first test panel configured to be mounted to the opening and to interface the first instance of electronic circuitry with a first electronic device.

8. The assembly of Claim 7, wherein the first test panel is removably and interchangeably mounted to the first opening.

9. The assembly of Claim 7, wherein the first test panel comprises a single continuous planar metallic material that has been machined, in accordance with the first software test, with a first arrangement of a plurality of through-holes.

10. The assembly of Claim 9, wherein each through-hole of the plurality of through-holes is adapted to receive a respective externally operable electronic component associated with the first instance of electronic circuitry.

11. The assembly of Claim 10, wherein the externally operable electronic component comprises a switch, terminal connector, Dsub connector, banana jack, numerical display, speaker, or adjustable potentiometer.

12. The assembly of Claim 9, further comprising a second test panel configured to be mounted to the opening, the second test panel comprising a single continuous planar metallic material that has been machined, in accordance with a second software test, with a second arrangement of a plurality of through-holes.
